# EUROPÄISCHE PATENTANMELDUNG

(11) **EP 2 511 960 A2**
(43) Veröffentlichungstag der Anmeldung: **17.10.2012**
(21) Anmeldenummer: 12075028.6
(22) Anmeldetag: 14.03.2012
(51) Int. Cl.: H01L 31/042

(54) **Rahmenartige Halterung für ein Solarpaneel mit einer Kabelhalterung**

(30) Priorität: 13.04.2011 US 201113085505
(71) Anmelder: SOLON SE, 12489 Berlin (DE)
(72) Erfinder: Rentfrow, Greg, 85747 Tucson, Arizona (US)

(57) **Zusammenfassung**

In der Regel verläuft das Elektrokabel für den Anschluss eines Solarpaneels ungeführt durch den freien Raum, sodass es zu Behinderungen und Beschädigungen während des Transports und der Montage des Solarpaneels kommen kann. Erfindungsgemäß ist deshalb in den unteren, parallel zum Solarmodul (24) verlaufenden Schenkel (27) eines L-förmigen Profils (20), das der rahmenartigen Halterung des Solarpaneels (24) dient, eine Kabelhalterung (08) integriert. Dabei ist die Kabelhalterung (08) als entlang der Stirnseite (56) des parallelen Schenkels (27) verlaufende Nut (09) ausgebildet, in die das Elektrokabel (10) einleg- und halterbar ist. Dadurch durchzieht oder überspannt das Elektrokabel (10) nicht mehr den freien Raum, sondern ist sicher eingelagert und geführt. Eine Behinderung des Montagepersonals oder ein Herausreißen des Elektrokabels (10) während des Transports und der Montage sind zuverlässig vermieden. Bevorzugt können mehrere Elektrokabel in die Nut eingelegt und mit Niederhaltern gesichert werden.

## Beschreibung

Die Erfindung bezieht sich auf eine rahmenartige Halterung für ein Solarpaneel aus einem in der Basis L-förmigen Profil mit zumindest einem bezogen auf das Solarpaneel orthogonalen Schenkel und zumindest einem parallelen Schenkel, der an den orthogonalen Schenkel an dessen vom Solarpaneel abgewandten Ende anschließt, und einer Kabelhalterung an der Stirnseite des parallelen Schenkels zur Halterung zumindest eines Elektrokabels.

Solarpaneele tragen die Solarzellen zur direkten Erzeugung von elektrischem Strom und bilden das Kernstück eines Solarmoduls. Solarpaneele können flexibel einlaminiert oder starr auf Glasabdeckplatten aufgebracht sein. Sie werden über eine rahmenartige Halterung, die entweder unterhalb der Solarpaneele angeordnet ist (Bildung eines Solarmoduls ohne Rahmen) oder den Rand des Solarpaneels umgreift (Bildung eines Solarmoduls mit Rahmen) mit einem Substrat, in der Regel ein Schräg- oder Flachdach, verbunden. Das Solarmodul kommt fertig endmontiert an die Montagestelle und wird auf dem Substrat montiert. Alle Solarmodule haben Elektrokabel, mit denen sie untereinander und schließlich mit einer stromableitenden Vorrichtung, beispielsweise ein Wandler oder eine Batterie, verbunden werden. Während der Montage können die freien Elektrokabel hinderlich oder sogar gefährlich für die Monteure sein. Abgerissene Elektrokabel sind nur aufwändig zu reparieren. Auch im montierten Zustand können auf dem Substrat aufliegende Elektrokabel störend sein. Daher sind im Stand der Technik Kabelhalterungen vorgesehen, die das Elektrokabel an der rahmenartigen Halterung des Solarmoduls fixieren und sichern.

### STAND DER TECHNIK

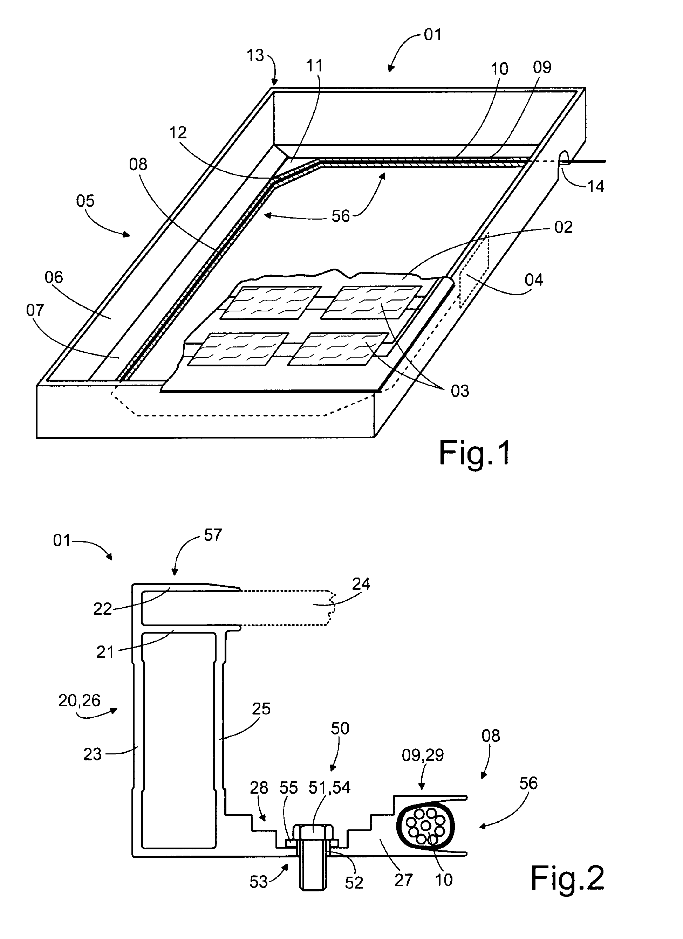

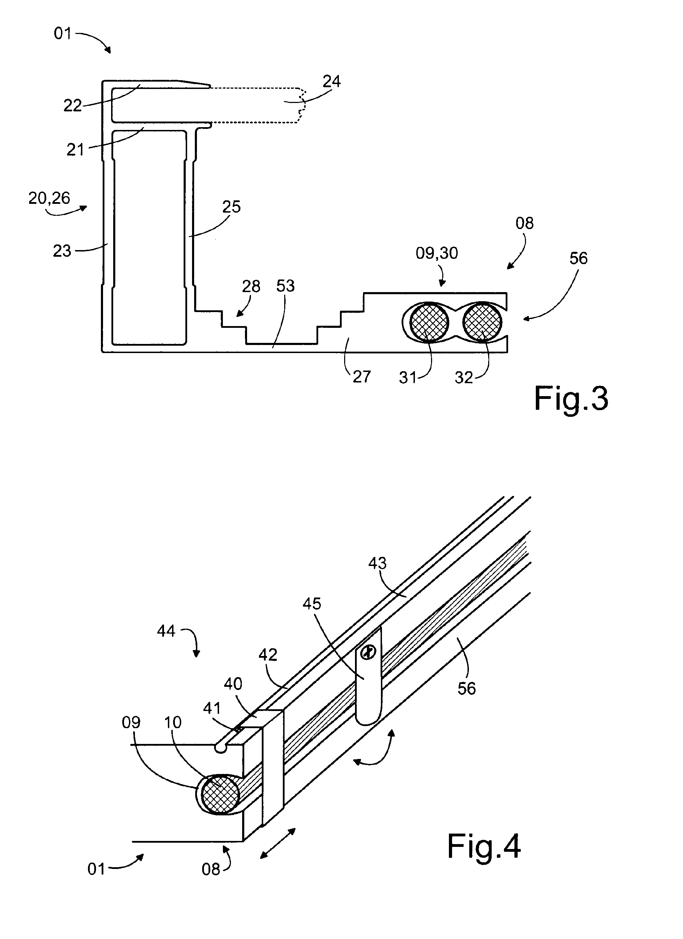

Aus der US 7 406 800 B2 ist es für ein gerahmtes Solarpaneel bekannt, die Kabel zwischen den einzelnen Rahmen durch Nuten zu führen, die zwar in der Stirnwand des Rahmenprofils liegen, sich aber nicht entlang des Profils erstrecken, sondern orthogonal dazu verlaufen (vergleiche Abbildung 2A). Die Kabelhalterungen sind also im Sinne von Kabeldurchführungen zwischen den einzelnen Solarpaneelen aufzufassen und dienen nicht der Kabelhalterung des einzelnen Solarpaneels. Aus der DE 102005 032 716 A1 ist es weiterhin bekannt, das Elektrokabel auf der Unterseite des Rahmens eines Solarpaneels in einer muldenartigen Nut zu positionieren und mit einer Schutzfolie zu fixieren (vergleiche Abbildung 4). Die Nut erstreckt sich zwar entlang des Rahmens, ist aber nicht im Bereich der Stirnseite angeordnet und dient auch nicht der Halterung des Elektrokabels.

Der der Erfindung nächstliegende Stand der Technik wird hingegen in der DE 20 2008 009 758 U1 offenbart. In der Abbildung 2 ist eine rahmenartige Halterung für ein Solarpaneel dargestellt, die aus einem in der Basis L-förmigen Profil mit zumindest einem bezogen auf das Solarpaneel orthogonalen und zumindest einem parallelen Schenkel besteht, wobei der parallele Schenkel an den orthogonalen Schenkel an dessen vom Solarpaneel abgewandten Ende anschließt. Im Bereich der Stirnseite des parallelen Schenkels ist eine Kabelhalterung zur Halterung eines Elektrokabels vorgesehen. Die Kabelhalterung besteht aus einer gebogenen Klammer, die über die Stirnseite des parallelen Schenkels greift und auf der Unterseite des Schenkels in eine Nut im Bereich des orthogonalen Schenkels einrastet. Auf der Innenseite des parallelen Schenkels weist die Klammer einen geraden Steg auf, an oder hinter dem das Elektrokabel fixierbar ist, weitere Ausführungen zur Fixierung des Elektrokabels werden nicht gegeben. An der dem Solarpaneel zugewandten Seite des orthogonalen Schenkels befinden sich zwei weitere parallele Schenkel, die das Solarpaneel an seinem Rand umgreifen, sodass ein gerahmtes Solarmodul entsteht. An den Innenecken jeweils an den parallelen Schenkeln weist die bekannte Halterung jeweils einen nutartigen Kanal auf, der sich entlang des Profils erstreckt. Diese Kanäle dienen aber nicht der Halterung von Elektrokabeln, sondern der Aufnahme von Schrauben zur orthogonalen Eckverbindung von jeweils zwei Profilen. Es handelt sich um so genannte Schraubkanäle, die durch Verformung die Schrauben festhalten.

Derartige Schraubkanäle sind auch aus der EP 1 146 297 A1 (vergleiche Abbildung 3 für ein rahmenloses Solarmodul) und der US 2009/0194098 A1 (vergleiche Abbildung 6 für ein gerahmtes Solarmodul) bekannt. Auch hier dienen die Schraubkanäle der Aufnahme von Schrauben zur Herstellung einer Eckverbindung. Spezielle Kabelhalterungen sind bei den rahmenartigen Halterungen gemäß diesen beiden Druckschriften nicht vorgesehen.

Aus der JP 11062143 A ist ebenfalls ein Rahmen mit nutenartigen Kanälen bekannt. Dieser Rahmen dient aber der gleichzeitigen Aufnahme von zwei Solarpaneelen und ist durch die Nuten in gewissem Maß verformbar. Nach Einlegen der Solarpaneele wird zentral ein Fixierungsstück eingedrückt, das in Führungsnuten einrastet. Durch die Verformung der darunter liegenden Nuten beim Eindrücken wird eine Rückstellkraft erzeugt, die das Fixierungsstück und damit die beiden Solarpaneele fixiert.

### AUFGABENSTELLUNG

Die **AUFGABE** für die vorliegende Erfindung ist darin zu sehen, die oben beschriebene gattungsgemäße rahmenartige Halterung für ein Solarpaneel so weiterzubilden, dass eine Halterung von Elektrokabeln in einfacher, aber zuverlässiger Weise möglich ist. Die Erfindungsgemäße LösuNG für diese Aufgabe ist dem Hauptanspruch zu entnehmen, vorteilhafte Weiterbildungen der Erfindung werden in den Unteransprüchen aufgezeigt und im Folgenden im Zusammenhang mit der Erfindung näher erläutert.

Bei der erfindungsgemäßen rahmenartigen Halterung ist die Kabelhalterung in die Stirnseite des parallelen Schenkels des L-förmigen Profils integriert und besteht aus einer entlang der Stirnseite verlaufenden Nut, in die das Elektrokabel einleg- und halterbar ist. Dadurch wird das Elektrokabel entlang der rahmenartigen Halterung geführt. Freischwingende oder den Rahmen quer überspannende Elektrokabel sind durch die Erfindungsgemäße Halterung sowohl während der Lagerung und des Transports des Solarmoduls als auch während und nach der Montage sicher verhindert. In der Nut ist das Elektrokabel vor Beschädigungen sicher geschützt. Dabei kann die Nut in der Stirnseite des parallelen Schenkels des L-förmigen Profils abschnittsweise oder durchgängig verlaufen. Auch bei einem abschnittsweisen Verlauf ist die Halterung des Elektrokabels gewährleistet. Im Bereich von weiteren Konstruktionselementen, beispielsweise Auflagern für die rahmenartige Halterung auf dem Substrat, ist die Nut entsprechend unterbrochen, da in diesen Bereichen die Einlegung des Elektrokabels ggfs. nur erschwert möglich ist. Eine besonders zuverlässige Führung ergibt sich, wenn die Nut durchgängig ausgeprägt ist und das Elektrokabel über möglichst weite Strecken in die Nut eingelegt ist. Auch bei einer durchgängigen Nut kann das Elektrokabel streckenweise an unzugänglichen Stellen nicht eingelegt werden.

Grundsätzlich wird das eingelegte Elektrokabel in der Nut durch einfachen Reibschluss gehalten, d.h. eingeklemmt. Dafür ist es vorteilhaft, wenn die Nut einen gerundeten Querschnitt aufweist. Die Tiefe der Nut ist in Abhängigkeit von der Ausführungsform des L-förmigen Profils gestaltbar. Insbesondere kann die Nut so tief ausgeführt sein, dass nur ein Elektrokabel eingelegt werden kann. Es kann aber auch eine Nut mit einer größeren Tiefe verwendet werden, in die beispielsweise zwei Elektrokabel übereinander eingelegt werden können. Um einen sicheren Klemmsitz beider Elektrokabel zu gewährleisten, ist es vorteilhaft, wenn der Querschnitt der Nut nach der Form einer Acht gerundet ist. Bei einer entsprechenden Breite der Stirnseite des parallelen Schenkels können natürlich auf zwei oder mehr Elektrokabel über die Höhe der Stirnseite in entsprechende Nuten eingelegt werden.

Vorteilhaft ist auch eine sichere Führung des Elektrokabels in den Ecken. In scharfen Ecken kann das Elektrokabel nicht vollständig geführt werden, da es dann knicken würde. Grundsätzlich kann das Elektrokabel frei durch die Ecke von der Nut in dem parallelen Schenkel des einen L-Profils zur Nut in dem parallelen Schenkel des anderen L-Profils gezogen werden. Dazu sind entsprechende seitliche Aussparungen in den Nuten vorzusehen. Zwischen den Nuten kann aber auch ein Eckstück pro Ecke angeordnet sein, das ebenfalls eine Nut trägt und das Elektrokabel auch durch die Ecke sicher haltert und führt. Dabei sind die Eckstücke besonders leicht vorzusehen, wenn die rahmenartige Halterung rechteckig ausgebildet ist und rechtwinklige Innenecken aufweist.

Die rahmenartige Halterung bei der Erfindung basiert auf einem L-förmigen Profil. Das Profil ist also in seinem prinzipiellen Aufbau einen L mit einem zum Solarpaneel orthogonalen Schenkel und einen dazu parallelen Schenkel nachempfunden, der in der Regel kürzer ist als der orthogonale Schenkel. Dabei befindet sich der eine parallele Schenkel am vom Solarpaneel abgewandten Ende des orthogonalen Schenkels und dient der Lagerung des Solarpaneels auf dem Substrat und nicht der Lagerung des Solarpaneels in der rahmenartigen Halterung. Dafür kann bevorzugt ein weiterer paralleler Schenkel des L-förmigen Profils vorgesehen sein, der an den orthogonalen Schenkel an dessen dem Solarpaneel zugewandten Ende anschließt und unter dem Solarpaneel in dessen Randbereich befestigbar ist. Durch diese Ausgestaltung ergibt sich eine so genannte "rahmenlose" Halterung der Solarpaneels, bei der das Profil unterhalb des Solarpaneels verläuft und somit von oben nicht sichtbar ist. Schmutzkanten auf dem Solarpaneel werden so vermieden, außerdem ergibt sich ein ungestörter Gesamteindruck auf die montierten Solarpaneele. Es können aber auch zwei weitere parallele Schenkel am L-förmigen Profil vorgesehen sein, die an den orthogonalen Schenkel an dessen dem Solarpaneel zugewandten Ende anschließen und den Randbereich der Solarpaneels U-förmig umschließen. Dadurch ergibt sich eine Rahmeneinfassung des Solarpaneels, die besonders sicher ist und das Solarpaneel auch an seiner umlaufenden Seitenkante schützt. Die Stützfunktion des Solarpaneels auf dem Substrat wird von dem orthogonalen Schenkels des L-Profils übernommen. Zur Verbesserung seiner Stabilität kann bevorzugt ein weiterer orthogonaler Schenkel vorgesehen sein, der parallel zu dem ersten parallelen Schenkel verläuft. Weitere Ausgestaltungen des L-förmigen Profils, beispielsweise zusätzliche Abstufungen oder Bohrungen, sind problemlos beispielsweise aus Aluminium im Stranggussverfahren, realisierbar, hierzu wird auf die Ausführungsbeispiele verwiesen.

Grundsätzlich halten die Elektrokabel in der Nut bereits ausschließlich durch Reibung. Um eine zusätzliche Sicherung zu erhalten, beispielsweise auch unter Zugkräften auf das Elektrokabel, ist es vorteilhaft, einfache Aufsteckclipse oder andere Verriegelungselemente, beispielsweise einfache Riegel, zur Sicherung des Elektrokabels in der Nut vorzusehen, die einfach auf die Nut aufgesteckt oder darüber geklappt oder geschoben werden. Weiterhin kann vorteilhaft und bevorzugt die Befestigung des L-förmigen Profils auf dem Untergrund mit einer Schraube erfolgen, die durch eine Bohrung in einer Aussparung des L-förmigen Profils geführt wird. Zur Kraftverteilung des Schraubenkopfes ist in die Aussparung noch eine Unterlegscheibe eingelegt. Weiteres ist den nachfolgenden Ausführungsbeispielen zu entnehmen.

### AUSFÜHRUNGSBEISPIELE

Ausbildungsformen der rahmenartigen Halterung nach der Erfindung werden nachfolgend zum weiteren Verständnis der Erfindung näher erläutert. Dabei zeigt:
- **FIGUR 1**: in der Perspektive eine rahmenartige Halterung mit einem Solarpaneel,
- **FIGUR 2**: einen Querschnitt durch ein erstes L-förmiges Profil,
- **FIGUR 3**: einen Querschnitt durch ein zweites L-förmiges Profil im Ausschnitt und
- **FIGUR 4**: in der Perspektive verschiedene Verriegelungselemente.

Die **FIGUR 1** zeigt im Ausschnitt perspektivisch eine rechteckige rahmenartige Halterung **01** für ein Solarpaneel **02** mit Solarzellen **03**, die in einer Anschlussdose **04** verschaltet sind. Die rahmenartige Halterung **01** besteht aus einem in der Basis L-förmigen Profil **05** mit zumindest einem bezogen auf das Solarpaneel **02** orthogonalen Schenkel **06** und zumindest einem bezogen auf das Solarpaneel **02** parallelen Schenkel **07**. Dabei schließt der orthogonale Schenkel **06** mit seinem einen Ende unterhalb an das Solarpaneel **02** an, sodass dieses in der Aufsicht als rahmenlos erscheint. Der parallele Schenkel **07** schließt an das vom Solarpaneel **02** abgewandte Ende des orthogonalen Schenkels **06** an. In einer Stirnseite **56** des parallelen Schenkels **07** ist eine Kabelhalterung **08** in Form einer längsverlaufenden Nut **09** integriert, in die im gezeigten Ausführungsbeispiel ein Elektrokabel **10** eingelegt und gehalten ist.

In der **FIGUR 1** ist weiterhin ein Eckstück **11** mit einer die benachbarten Nuten **09** verbindenden Ecknut **12** dargestellt, in dem das Elektrokabel **10** durch die rechtwinklige Innenecke **13** geführt ist. Im gezeigten Ausführungsbeispiel wird das Elektrokabel **10** bei der Anschlussdose **04** beginnend durch nahezu den gesamten Innenbereich der rahmenartigen Halterung **01** in den Nuten **09, 12** geführt und verlässt dann über einen Durchbruch **14** die rahmenartige Halterung **01**, um zur benachbarten rahmenartigen Halterung oder einem anderen funktionalen Element, beispielsweise einem Gleich- oder Wechselrichter oder einer Batterie (alle nicht dargestellt), geführt zu werden. Dabei ist eine durchgängige Führung des Elektrokabels **10** in der Nut **09** dargestellt, sodass das Elektrokabel **10** nicht frei hängen kann und keine Gefährdung darstellt.

In der **FIGUR 2** ist ein anderes, prinzipiell L-förmiges Profil **20** im Querschnitt dargestellt, das zwei weitere parallele Schenkel **21, 22** aufweist, die an den orthogonalen Schenkel **23** an dessen dem Solarpaneel **24** zugewandten Ende anschließen und den Randbereich **57** der Solarpaneels **24** U-förmig umschließen. In der Aufsicht erscheint das Solarpaneel **24** somit gerahmt. Des Weiteren weist das L-förmige Profil **20** noch einen weiteren orthogonalen Schenkel **25** auf, der parallel zu dem ersten orthogonalen Schenkel **23** verläuft und das L-förmige Profil **20** nach der Art eines Hohlkammerprofils mechanisch verstärkt. Dies ist insbesondere dann von Vorteil, wenn es sich bei dem L-förmigen Profil **20** um ein einfaches stranggegossenes Aluminiumprofil **26** handelt. Zur Vermeidung von Kerbkräften und zur Verstärkung weist der parallele Schenkel **27** des L-förmigen Profils **20** noch treppenförmige Abstufungen **28** auf. Zu erkennen ist weiterhin eine Nut **29** mit gerundetem Querschnitt, in die das Elektrokabel **10** eingeklemmt ist.

In der **FIGUR 2** ist als Detail noch eine Befestigung **50** des L-förmigen Profils **20** auf dem Untergrund (nicht gezeigt) mit Schrauben **51** dargestellt, die durch Bohrungen **52** in einer länglichen, rechteckigen Aussparung **53** des L-förmigen Profils **20** in den treppenförmigen Abstufungen **28** geführt wird. Zur Kraftverteilung der Schraubenköpfe **54** sind in die Aussparung **53** noch Unterlegscheiben **55** eingelegt.

Die **FIGUR 3** entspricht der **FIGUR 2** mit dem Unterschied, dass eine Doppelnut **30** mit einem nach der Form einer Acht doppelt gerundeten Querschnitt im Ausschnitt dargestellt ist, in die zwei Elektrokabel **31, 32** hintereinander einschiebbar sind. gezeigt ist eine Ausführungsform, in der die beiden Elektrokabel **31, 32** nebeneinander liegend angeordnet sind. In Abhängigkeit von der Breite der Stirnseite **56** können die beiden Elektrokabel **31, 32** natürlich auch übereinander liegend angeordnet werden. In Abhängigkeit von der Ausprägung des parallelen Schenkels **27** des L-förmigen Profils **20** können auch mehr als zwei Elektrokabel **31, 32** in die Kabelhalterung **08** eingelegt und gehaltert werden.

In der Regel hält das Elektrokabel **10** in der Nut **09** bereits durch Reibschluss. In der **FIGUR 4** sind in der Perspektive noch ein Aufsteckclips **40**, der mit Verdickungen **41** in kleine Nuten **42** in den parallelen Schenkel **43** des L-förmigen Profils **44** eingeclipst wird, und alternativ ein weiteres Verriegelungselement **45**, hier in Form einer einfachen drehbaren Lasche **46**, zum sicheren Rückhalten des Elektrokabels **10** in der Nut **09 -** auch beispielsweise unter Zug - dargestellt.

Nicht in einer Figur erwähnte Bezugszeichen sind den anderen Figuren zu entnehmen. Die gezeigten Ausführungsformen der Erfindung sind als Beispiele zu verstehen. Weitere Ausführungsformen der Erfindung sind ohne weiteres möglich.

### BEZUGSZEICHENLISTE

- **01**: rahmenartige Halterung
- **02**: Solarpaneel
- **03**: Solarzelle
- **04**: Anschlussdose
- **05**: L-förmiges Profil
- **06**: orthogonaler Schenkel
- **07**: paralleler Schenkel
- **08**: Kabelhalterung
- **09**: Nut
- **10**: Elektrokabel
- **11**: Eckstück
- **12**: Ecknut
- **13**: Innenecke
- **14**: Durchbruch

- **20**: L-förmiges Profil
- **21**: erster weiterer paralleler Schenkel
- **22**: zweiter weiterer paralleler Schenkel
- **23**: orthogonaler Schenkel
- **24**: Solarpaneel
- **25**: weiterer paralleler orthogonaler Schenkel
- **26**: Aluminiumprofil
- **27**: paralleler Schenkel
- **28**: treppenförmige Abstufung
- **29**: Nut mit gerundetem Querschnitt

- **30**: Doppelnut
- **31**: erstes Elektrokabel
- **32**: zweites Elektrokabel
- **40**: Aufsteckclip
- **41**: Verdickung
- **42**: kleine Nut
- **43**: paralleler Schenkel
- **44**: L-förmiges Profil
- **45**: weiteres Verriegelungselement

- **50**: Befestigung
- **51**: Schraube
- **52**: Bohrung
- **53**: Aussparung
- **54**: Schraubenkopf
- **55**: Unterlegscheibe
- **56**: Stirnseite von 07, 27
- **57**: Randbereich von 02, 24

## Patentansprüche

1. Rahmenartige Halterung (01) für ein Solarpaneel (02) aus einem in der Basis L-förmigen Profil (05) mit zumindest einem bezogen auf die Einbaulage des Solarpaneels (02) orthogonalen Schenkel (06) und zumindest einem parallelen Schenkel (07), der an den orthogonalen Schenkel (06) an dessen vom Solarpaneel (02) abgewandten Ende anschließt, und einer Kabelhalterung (08) an der Stirnseite (56) des parallelen Schenkels (07) zur Halterung zumindest eines Elektrokabels (10),
**GEKENNZEICHNET DURCH**
eine Integration der Kabelhalterung (08) in die Stirnseite (56) des parallelen Schenkels (07) des L-förmigen Profils (05) und eine Ausbildung der Kabelhalterung (08) als entlang der Stirnseite (56) verlaufende Nut (09), in die das Elektrokabel (10) einleg- und halterbar ist.

2. Rahmenartige Halterung (01) nach Anspruch 1,
**GEKENNZEICHNET DURCH**
einen abschnittsweisen oder durchgängigen Verlauf der Nut (09) in der Stirnseite (56) des parallelen Schenkels (07) des L-förmigen Profils (05).

3. Rahmenartige Halterung (01) nach Anspruch 1 oder 2,
**GEKENNZEICHNET DURCH**
einen einfach gerundeten Querschnitt der Nut (29), in den das Elektrokabel (10) einleg- und halterbar ist.

4. Rahmenartige Halterung (01) nach Anspruch 1 oder 2,
**GEKENNZEICHNET DURCH**
eine Doppelnut (30) mit einem nach der Form einer Acht doppelt gerundeten Querschnitt, in die zwei Elektrokabel (31,32) einleg- und halterbar sind.

5. Rahmenartige Halterung (01) nach zumindest einem der Ansprüche 1 bis 4, **GEKENNZEICHNET DURCH**
eine rechteckige Ausbildung der rahmenartigen Halterung (01) mit rechtwinkligen Innenecken (13), in denen jeweils ein Eckstück (11) mit einer an die benachbarten Nuten (09) in den Stirnseiten (56) der parallelen Schenkel (07) der L-förmigen Profile (05) anschließenden Ecknut (12) angeordnet ist.

6. Rahmenartige Halterung (01) nach zumindest einem der Ansprüche 1 bis 5, **GEKENNZEICHNET DURCH**
einen weiteren parallelen Schenkel (21) des L-förmigen Profils (20), der an den orthogonalen Schenkel (23) an dessen dem Solarpaneel (24) zugewandten Ende anschließt und unter dem Solarpaneel (24) in einem Randbereich (57) befestigbar ist.

7. Rahmenartige Halterung (01) nach zumindest einem der Ansprüche 1 bis 5, **GEKENNZEICHNET DURCH**
zwei weitere parallele Schenkel (21, 22) des L-förmigen Profils (29), die an den orthogonalen Schenkel (23) an dessen dem Solarpaneel (24) zugewandten Ende anschließen und für eine U-förmige Umschließung eines Randbereichs (57) der Solarpaneels (24) ausgebildet sind.

8. Rahmenartige Halterung (01) nach zumindest einem der Ansprüche 1 bis 7, **GEKENNZEICHNET DURCH**
einen weiteren orthogonalen Schenkel (25) des L-förmigen Profils (20), der parallel zu dem ersten orthogonalen Schenkel (23) verläuft.

9. Rahmenartige Halterung (01) nach zumindest einem der Ansprüche 1 bis 8, **GEKENNZEICHNET DURCH**
Aufsteckclipse (40) oder Verriegelungselemente (45) zum Niederhalten des eingelegten Elektrokabels (10 in der Nut (09) im L-förmigen Profil (44).

10. Rahmenartige Halterung (01) nach zumindest einem der Ansprüche 1 bis 9,
**GEKENNZEICHNET DURCH**
eine Ausbildung des L-förmigen Profils (20) als stranggegossenes Aluminiumprofil (26).

11. Rahmenartige Halterung (01) nach zumindest einem der Ansprüche 1 bis 10,
**GEKENNZEICHNET DURCH**
eine Befestigung des L-förmigen Profils (20) mittels Schrauben (51) und Unterlegscheiben (55) in einer Aussparung (53) des L-förmigen Profils (20).
